# EUROPÄISCHE PATENTSCHRIFT

(11) **EP 3 748 599 B1**
(45) Veröffentlichungstag und Bekanntmachung des Hinweises auf die Patenterteilung: **28.07.2021**
(21) Anmeldenummer: 19177938.8
(22) Anmeldetag: 03.06.2019
(51) Int. Cl.: G08B 29/12

(54) **VERFAHREN ZUM BETRIEB UND TESTS EINES GEFAHRENMELDESYSTEMS MIT EINEM BUSSYSTEM, MELDER ZUM ANSCHLUSS AN EIN BUSSYSTEM UND GEFAHRENMELDESYSTEM MIT EINEM BUSSYSTEM.**
METHOD FOR OPERATING AND TESTING A HAZARD SIGNALING SYSTEM WITH A BUS SYSTEM, DETECTOR FOR CONNECTING TO A BUS SYSTEM AND HAZARD SIGNALLING SYSTEM WITH A BUS SYSTEM.
PROCÉDÉ POUR OPÉRER ET TESTER UN SYSTÈME DE SIGNALISATION DE DANGER AVEC UN SYSTÈME DE BUS, DÉTECTEURS POUR CONNEXION À UN SYSTÈME DE BUS ET SYSTÈME DE SIGNALISATION DE DANGER AVEC UN SYSTÈME DE BUS.

(43) Veröffentlichungstag der Anmeldung: 09.12.2020
(73) Patentinhaber: Siemens Schweiz AG, 8047 Zürich (CH)
(72) Erfinder: Kästli, Urs, 8708 Männedorf (CH); Wenzler, Marc, 8810 Horgen (CH); Baertschi, Peter, 6312 Steinhausen (CH); Hofer, Peter Philip, 8810 Horgen (CH); Shen, Xue Song, Beijing, 102208 (CN)
(74) Vertreter: Maier, Daniel Oliver

(56) Entgegenhaltungen:
- EP-A1- 2 393 073
- EP-A1- 3 154 220
- WO-A1-2011/117168

## Beschreibung

Die vorliegende Erfindung betrifft ein Verfahren zum Betrieb einer Mehrzahl von an ein Bussystem angeschlossenen Meldern einer in einem Gebäude installierten Gefahrenmeldeanlage, nämlich ein Verfahren zum Test der Melder und des Bussystems während des Betriebs. Die Erfindung betrifft im Weiteren auch einen zur Verwendung im Rahmen des Tests bestimmten Melder und ein Gefahrenmeldesystem mit einer Mehrzahl von solchen Meldern, die an ein dortiges Bussystem angeschlossen sind. Als Melder werden hier und im Folgenden solche an ein Bussystem anschließbare und beim Betrieb an ein Bussystem angeschlossene Melder verstanden, welche ein Signal, zum Beispiel ein optisches und/oder akustisches Signal, ausgeben, welches für die Benutzer eines Gebäudes bestimmt ist. Ein Melder in diesem Sinne ist also zum Beispiel eine Blitzleuchte, ein Signalhorn und dergleichen.

In der Gebäudeautomation werden zur Verbindung dort vorgesehener Sensoren und Aktoren aufgrund der resultierenden Flexibilität mehr und mehr Bussysteme, zum Beispiel Feldbusse, eingesetzt. Für einen sicheren Betrieb eines Gefahrenmeldesystems mit einer Mehrzahl von an das Bussystem angeschlossenen Meldern ist selbstverständlich erforderlich, dass das Bussystem zum Beispiel auch im Falle eines sogenannten einfachen Fehlers (Drahtbruch oder Kurzschluss) funktionsfähig ist, dass der elektrisch leitende Anschluss jedes Melders an das Bussystem ordnungsgemäß ausgeführt ist und ordnungsgemäß besteht sowie dass ein Energieverbrauch/-bedarf eines jeden einzelnen Melders innerhalb vorgegebener Grenzen bleibt, insbesondere dass eine Betriebsspannung jedes Melders innerhalb vorgegebener Grenzen bleibt.

Bei einem Bussystem ist erforderlich, dass dessen Busleitungen die erforderlichen elektrischen Eigenschaften aufweisen und dass alle Busleitungen entlang der gesamten räumlichen Erstreckung des Bussystems leitend sind sowie gleichmäßige elektrische Eigenschaften aufweisen. Fehler in einem Bussystem können sich zum Beispiel aufgrund von Kabelbruch ergeben. Bei einem ordnungsgemäß ausgeführten Anschluss eines Melders an ein Bussystem sind Schraubverbindungen oder dergleichen oder Lötverbindungen so ausgeführt, dass ein Anschluss mit dauerhaft gleichbleibenden elektrischen Eigenschaften gewährleistet ist. Korrosion oder sonstige Umwelteinflüsse können bei einem ursprünglich ordnungsgemäß ausgeführten Anschluss eines Melders dazu führen, dass der Anschluss nach einiger Zeit nicht mehr ordnungsgemäß besteht. Ein Melder mit einem Kurzschluss oder einer sonstigen internen Fehlfunktion kann korrekt angeschlossen sein, führt aber zum Beispiel aufgrund eines bei einem Kurzschluss resultierenden Kurzschlussstroms zu einem erhöhten Energieverbrauch am Bussystem.

Bisher erfolgt ein Test eines Gefahrenmeldesystems mit einer Mehrzahl von an ein Bussystem angeschlossenen Meldern, indem die an das Bussystem angeschlossenen Melder wie bei einer Alarmsituation aktiviert werden. Ein Melder eines solchen Gefahrenmeldesystems gibt also während des Tests zum Beispiel akustische und/oder optische Signale ab, die normalerweise auf eine Alarmsituation hinweisen. Ein solcher Test ist deshalb in einem Gebäude normalerweise nicht möglich, wenn sich Benutzer in dem Gebäude aufhalten.

Zur Überwachung ordnungsgemäß ausgeführter und ordnungsgemäß bestehender Anschlüsse aller an ein Bussystem angeschlossener Melder ist eine Überwachung des Gesamtwiderstands des Bussystems (line resistance) eine übliche Methode und zum Beispiel in der US 8,405,400 beschrieben. Sonderfälle bei Stichleitungen sind zum Beispiel aus der WO 2011/117168 A1, aus der EP 2 105 898 A1 und der WO 2013/089932 A1 bekannt.

Ein Verfahren zum Testen eines Melders ist zum Beispiel aus der US 7,333,010 bekannt. Dort geht es speziell um einen Test bei niedrigen Spannungen, zum Beispiel aufgrund nachlassender Batterieladung. Es werden eine an das Bussystem abgegebene Speisespannung, ein in Bezug auf einen Melder aufgenommener Messwert und/oder eine in Bezug auf den Melder ermittelte Impedanz verwendet, um eine Aussage zur Betriebsbereitschaft des Melders bei der jeweils abgegebenen Speisespannung zu machen.

Bei den aus dem genannten Stand der Technik bekannten Verfahren erfolgt beim Test jeweils eine Aktivierung der jeweiligen Signalelemente der Melder. Die Tests können also nicht jederzeit durchgeführt werden und eine automatische kontinuierliche Überwachung ist ebenfalls nicht möglich.

Eine Aufgabe der vorliegenden Erfindung besteht entsprechend darin, ein Testverfahren anzugeben, das jederzeit und optional auch automatisch regelmäßig durchgeführt werden kann, indem eine Aktivierung der Signalelemente der Melder unterbleibt.

Diese Aufgabe wird erfindungsgemäß mittels eines Testverfahrens mit den Merkmalen des Anspruchs 1 gelöst. Dazu ist - kurz gefasst - vorgesehen, dass jeder Melder zusätzlich zu jeweils zumindest einem Signalelement eine aktivierbare Energieverbrauchssimulationseinheit umfasst. Die Energieverbrauchssimulationseinheit wird im Folgenden mitunter kurz als Simulationseinheit bezeichnet. Beim Test wird in einem Melder anstelle des zumindest einen Signalelements die Simulationseinheit an das Bussystem angeschaltet. Das zumindest eine Signalelement ist dann inaktiv und beim Test unterbleibt eines Ausgabe von sonst mittels des jeweiligen Signalelements ausgegebenen optischen oder akustischen Signalen. Stattdessen ist die Simulationseinheit an das Bussystem angeschaltet. Die Simulationseinheit ist eine elektrische Last an dem Bussystem und tritt an die Stelle des zumindest einen Signalelements des jeweiligen Melders. Die Simulationseinheit hat zumindest bezüglich ihres Energieverbrauchs im Bussystem dieselben oder zumindest im Wesentlichen dieselben Eigenschaften wie die zumindest eine elektrische Last, welche sie im an das Bussystem angeschalteten Zustand ersetzt, also insbesondere dieselbe oder zumindest im Wesentlichen dieselbe Abhängigkeit der Klemmenspannung von der Stromstärke, denselben oder zumindest im Wesentlichen denselben Widerstand, dieselbe oder zumindest im Wesentlichen dieselbe Impedanz, dieselbe oder zumindest im Wesentlichen dieselbe Kapazität und/oder dieselbe oder zumindest im Wesentlichen dieselbe Induktivität. Wenn es im Folgenden bezüglich der elektrischen Eigenschaften der Simulationseinheit darum geht, dass diese im o.a. Sinne dieselben oder zumindest im Wesentlichen dieselben Eigenschaften hat, ist dies oftmals kurz nur als dieselbe Eigenschaft oder dieselben Eigenschaften geschrieben. Dann ist stets mitzulesen, dass es sich nicht notwendig um exakt dieselbe Eigenschaft oder exakt dieselben Eigenschaften handelt, sondern vielmehr um dieselbe oder zumindest im Wesentlichen dieselbe Eigenschaft oder dieselben oder zumindest im Wesentlichen dieselben Eigenschaften. Eine Variation im Bereich von bis zu 5% oder bis zu 10% gilt in diesem Sinne als "zumindest im Wesentlichen dieselbe Eigenschaft".

Nach dem hier vorgeschlagenen Ansatz umfasst ein Verfahren zum Test (Belastungstest) eines Gefahrenmeldesystems mit einer Mehrzahl von an ein Bussystem angeschlossenen Meldern, wobei jeder Melder eine aktivierbare Energieverbrauchssimulationseinheit (Simulationseinheit) umfasst und wobei der Test während des Betriebs des Gefahrenmeldesystems durchführbar ist oder durchgeführt wird, zumindest die folgenden Schritte: Jeder an das Bussystem angeschlossene Melder aktiviert seine Simulationseinheit auf einen Erhalt eines als Energieverbrauchssimulationssignal fungierenden Umschalttelegramms. Die Aktivierung der Simulationseinheit bedeutet, dass der jeweilige Melder seine Simulationseinheit anstelle des oder jedes von dem Melder umfassten Signalelements an das Bussystem anschaltet. Im Rahmen des Belastungstests wird sodann ein aufgrund der Aktivierung jeder Simulationseinheit resultierender Energieverbrauch im Bussystem und/oder spezifisch in jedem Melder erfasst und mit vorgegebenen oder vorgebbaren Vergleichswerten verglichen. In Abhängigkeit vom Ergebnis des Vergleichs wird ein Alarmsignal und/oder eine Fehlermeldung generiert.

Weil während des Tests (Belastungstest; load test) eine Aktivierung optischer oder akustischer Signalelemente sicher unterbleibt, kann der Test auch als "stiller Test" (silent test) bezeichnet werden.

Wenn während des Tests ein zu hoher in das Bussystem abgegebener Speisestrom fließt, ist dies ein zu hoher Energieverbrauch im Bussystem und es wird automatisch ein Alarmsignal und/oder eine Fehlermeldung generiert. Wenn während des Tests ein zu hoher Strom in eine aktivierte Simulationseinheit fließt, ist dies ein spezifisch in Bezug auf einen einzelnen Melder erkannter zu hoher Energieverbrauch im Bussystem und es wird automatisch ein Alarmsignal und/oder eine Fehlermeldung generiert.

Das hier vorgeschlagene Verfahren basiert auf Meldern, welche eine solche aktivierte Simulationseinheit aufweisen. Die Erfindung ist insoweit auch ein Melder, also zum Beispiel ein Brandmelder oder dergleichen, zum Anschluss an ein Bussystem und zur Verwendung in einem Gefahrenmeldesystem mit einer Mehrzahl von an ein Bussystem angeschlossenen Meldern sowie zur Verwendung in einem Verfahren der hier und im Folgenden beschriebenen Art. Der Melder zeichnet sich dadurch aus, dass dieser neben zumindest einem Signalelement eine aktivierbare Energieverbrauchssimulationseinheit (Simulationseinheit) umfasst und dass die Simulationseinheit automatisch durch den Melder auf einen Erhalt eines Umschalttelegramms anstelle des oder jedes Signalelements an das Bussystem anschaltbar ist und an das Bussystem angeschaltet wird.

Für die weitere Beschreibung gilt zur Vermeidung unnötiger Wiederholungen, dass Merkmale und Details, die im Zusammenhang mit dem hier vorgeschlagenen Testverfahren sowie eventueller Ausgestaltungen beschrieben sind, selbstverständlich auch für zur Durchführung des Verfahrens eingerichtete Melder und umgekehrt gelten. Dementsprechend kann das Verfahren auch mittels einzelner oder mehrerer Verfahrensmerkmale fortgebildet sein, die sich auf von einem Melder oder von mehreren Meldern ausgeführte Verfahrensschritte beziehen. Ebenso kann der oder jeder Melder auch durch Mittel zur Ausführung von im Rahmen des Verfahrens ausgeführten Verfahrensschritten fortgebildet sein. Bei jeder Erwähnung gegenständlicher Merkmale eines Melders ist entsprechend deren Verwendung in Rahmen des Verfahrens und sind daran anknüpfende Verfahrensschritte oder Verfahrensschrittfolgen stets mitzulesen. Ebenso sind bei einer Erläuterung von Verfahrensschritten oder Verfahrensschrittfolgen die zu deren Ausführung notwendigen Mittel eines Melders, des Bussystems oder einer Zentraleinheit des Bussystems stets mitzulesen.

Der Vorteil der Erfindung besteht darin, dass der Belastungstest durchgeführt werden kann, ohne dass dabei optische oder akustische Signalelemente aktiviert werden und der Belastungstest damit auch dann in einem Gebäude durchgeführt werden kann, wenn sich in dem Gebäude Benutzer des Gebäudes aufhalten.

Vorteilhafte Ausgestaltungen der Erfindung sind Gegenstand der Unteransprüche. Dabei verwendete Rückbeziehungen innerhalb der Ansprüche weisen auf die weitere Ausbildung des Gegenstandes des in Bezug genommenen Anspruchs durch die Merkmale des jeweiligen abhängigen Anspruchs hin. Sie sind nicht als ein Verzicht auf die Erzielung eines selbständigen, gegenständlichen Schutzes für die Merkmale oder Merkmalskombinationen eines abhängigen Anspruchs zu verstehen. Des Weiteren ist im Hinblick auf eine Auslegung der Ansprüche sowie der Beschreibung bei einer näheren Konkretisierung eines Merkmals in einem abhängigen Anspruch davon auszugehen, dass eine derartige Beschränkung in den jeweils vorangehenden Ansprüchen sowie einer allgemeineren Ausführungsform des gegenständlichen Testverfahrens / der gegenständlichen Vorrichtung nicht vorhanden ist. Jede Bezugnahme in der Beschreibung auf Aspekte abhängiger Ansprüche ist demnach auch ohne speziellen Hinweis ausdrücklich als Beschreibung optionaler Merkmale zu lesen.

Bei einer Ausführungsform des Testverfahrens erfasst eine am Bussystem als übergeordnete Einheit fungierende Zentraleinheit während des Belastungstests einen aufgrund der Aktivierung der oder jeder Simulationseinheit resultierenden Energieverbrauch im Bussystem, vergleicht einen charakteristischen Wert zum Energieverbrauch, zum Beispiel einen Strommesswert, mit einem vorgegebenen oder vorgebbaren Schwellwert und generiert in Abhängigkeit vom Ergebnis des Vergleichs das Alarmsignal und/oder die Fehlermeldung. Bei dieser Variante des Belastungstests wird der Energieverbrauch im Bussystem insgesamt betrachtet.

Bei einer alternativen oder zusätzlichen Ausführungsform des Testverfahrens erfasst jeder Melder während des Belastungstests und im Anschluss an die Aktivierung von dessen Simulationseinheit Messwerte bezüglich einer über der Simulationseinheit abfallenden Spannung und speichert einen sich während des Belastungstest ergebenden Minimalwert. Die am Bussystem als übergeordnete Einheit fungierende Zentraleinheit fragt im Anschluss an den Belastungstest bei jedem Melder den dort gespeicherten Minimalwert ab und vergleicht diesen mit einem vorgegebenen oder vorgebbaren Schwellwert, insbesondere einem melderspezifischen oder meldertypspezifischen vorgegebenen oder vorgebbaren Schwellwert. In Abhängigkeit vom Ergebnis des Vergleichs generiert die Zentraleinheit wiederum das Alarmsignal und/oder die Fehlermeldung. Bei dieser Variante des Belastungstests wird der Energieverbrauch jedes einzelnen an das Bussystem angeschlossenen Melders betrachtet.

Beide vorgenannten Varianten (Betrachtung des Energieverbrauchs im Bussystem insgesamt; Betrachtung des Energieverbrauchs jedes einzelnen Melders) können im Rahmen des Testverfahrens einzeln oder zusammen zu Anwendung kommen.

Bei einer speziellen Ausführungsform der Betrachtung des Energieverbrauchs jedes einzelnen Melders führt die Zentraleinheit den Belastungstest mehrstufig durch und reduziert bei jeder neuen Stufe eine an das Bussystem abgegebene Speisespannung. Die Reduktion der Speisespannung erfolgt dabei zum Beispiel mit einer vorgegebenen oder vorgebbaren Schrittweite ausgehend von einem vorgegebenen oder vorgebbaren Startwert in Richtung auf einen vorgegebenen oder vorgebbaren Zielwert. Diese Ausführungsform ist besonders günstig für Melder, deren Energieverbrauch von einer dem Melder über das Bussystem jeweils zugeführten Spannung abhängt, als zum Beispiel Melder mit einem Signalelement mit konstantem Widerstand. Indem die Speisespannung im Rahmen des Belastungstests sukzessive reduziert wird, nähert sich die Speisespannung der niedrigstmöglichen Betriebsspannung des jeweiligen Melders an. Auf diese Weise kann zum Beispiel der maximale Strom ermittelt werden, bei dem das Bussystem noch betrieben werden kann, und/oder die Systemreserve (Reserve des Bussystems) ermittelt werden, zum Beispiel in Bezug auf zusätzliche Melder, Spannungsschwankungen der Zentrale und/oder Änderungen des Leitungswiderstands (zum Beispiel temperaturabhängig oder aufgrund von Korrosion). Die Ermittlung der Systemreserve ermöglicht auch eine Abschätzung von Möglichkeiten zum weiteren Netzausbau, also insbesondere zum Anschluss weiterer Melder an das Bussystem.

Bei einer speziellen Ausführungsform des Belastungstests schaltet die Zentraleinheit während des Belastungstests eine Speiserichtung des Bussystems - eine Richtung, in welcher ein Strom in das Bussystem eingespeist wird - um und der Belastungstest beginnt vor einer solchen Umschaltung mit einer ersten Speiserichtung und wird nach der Umschaltung mit einer der ersten Speiserichtung entgegengesetzten zweiten Speiserichtung fortgesetzt und abgeschlossen. Eine solche Umschaltung der Speiserichtung ist vorteilhaft, weil damit dem Umstand Rechnung getragen werden kann, dass die Widerstandsverteilung - also die Verteilung der Widerstände angeschlossener Melder - am Bussystem nicht symmetrisch sein muss. Bei unterschiedlichen Speiserichtungen und bei einer unsymmetrischen Widerstandsverteilung ergeben sich also unterschiedliche Spannungsabfälle entlang der Busleitungen und mit der Umschaltung können die Verhältnisse in beide Richtungen geprüft werden. Es kann also zum Beispiel in beide Richtungen die niedrigstmögliche Speisespannung ermittelt werden, bei der alle Melder noch betrieben werden können. Eine solche Umschaltung ist des Weiteren vorteilhaft, weil damit auch dem Umstand Rechnung getragen werden kann, dass eine Betriebssicherheit des Bussystems zumindest im Falle eines einfachen Fehlers gewährleistet sein muss und daher zur Beherrschung eines solchen einfachen Fehlers eine automatische Umschaltung der Speiserichtung erfolgen kann. Bei einem Belastungstest mit einer Umschaltung der Speiserichtung kann die Betriebssicherheit des Bussystems für beide möglichen Speiserichtungen und damit auch die Betriebssicherheit für die im Fehlerfall resultierende Speiserichtung geprüft werden.

Bevorzugt und vorteilhaft wird das Testverfahren (der Belastungstest) automatisch regelmäßig, insbesondere zyklisch durchgeführt, indem die Zentraleinheit den Belastungstest zu vorgegebenen oder vorgebbaren Zeitpunkten automatisch durchführt. Eine regelmäßige Ausführung hilft auch, schleichende Veränderungen zu erkennen. Dann kann frühzeitig eingegriffen werden und die vollständige Funktionsfähigkeit des Systems (Gefahrenmeldesystem) bleibt erhalten. Zudem kann die regelmäßige Prüfung protokolliert und die Protokolle können für Dokumentationszwecke vorgehalten werden.

Bevorzugt und vorteilhaft wird das Testverfahren (der Belastungstest) automatisch durch die Zentraleinheit durchgeführt, wenn sich die Anzahl der Melder am Bussystem ändert, also zum Beispiel wenn ein neuer Melder an das Bussystem angeschlossen wird. Auch hier hilft die automatische Ausführung, die Funktionsfähigkeit des Systems (Gefahrenmeldesystem) zu prüfen und zu dokumentieren. Immer wenn eine Veränderung des Systems stattfindet, also ein Melder ausgetauscht wird und durch einen neuen Melder ersetzt wird, ein Melder entfernt wird oder ein zusätzlicher Melder an das Bussystem angeschlossen wird, können sich theoretisch Verhältnisse ergeben, bei denen ein sicherer Betrieb des Systems nicht mehr gewährleistet ist. Ein automatisch durchgeführter Test zeitnah im Anschluss an eine Veränderung des Systems gewährleistet, dass eventuelle Probleme beim Betrieb des veränderten Systems frühzeitig erkannt werden und rechtzeitig eingegriffen werden kann.

Nachfolgend wird ein Ausführungsbeispiel der Erfindung anhand der Zeichnung näher erläutert. Einander entsprechende Gegenstände oder Elemente sind in allen Figuren mit den gleichen Bezugszeichen versehen.

Das Ausführungsbeispiel ist nicht als Einschränkung der Erfindung zu verstehen. Vielmehr sind im Rahmen der vorliegenden Offenbarung durchaus auch Ergänzungen und Modifikationen möglich, insbesondere solche, die zum Beispiel durch Kombination oder Abwandlung von einzelnen in Verbindung mit den im allgemeinen oder speziellen Beschreibungsteil beschriebenen sowie in den Ansprüchen und/oder der Zeichnung enthaltenen Merkmalen oder Verfahrensschritten für den Fachmann im Hinblick auf die Lösung der Aufgabe entnehmbar sind und durch kombinierbare Merkmale zu einem neuen Gegenstand oder zu neuen Verfahrensschritten bzw. Verfahrensschrittfolgen führen.

Es zeigen
- FIG 1: ein Gefahrenmeldesystem mit einer Mehrzahl von an ein Bussystem angeschlossenen Meldern,
- FIG 2: einen an ein Bussystem anschließbaren Melder mit einer aktivierbaren Simulationseinheit,
- FIG 3: ein Gefahrenmeldesystem mit einer Mehrzahl von an ein Bussystem angeschlossenen Meldern mit aktivierbaren Simulationseinheiten und
- FIG 4: eine Zentraleinheit eines Bussystems gemäß FIG 3.

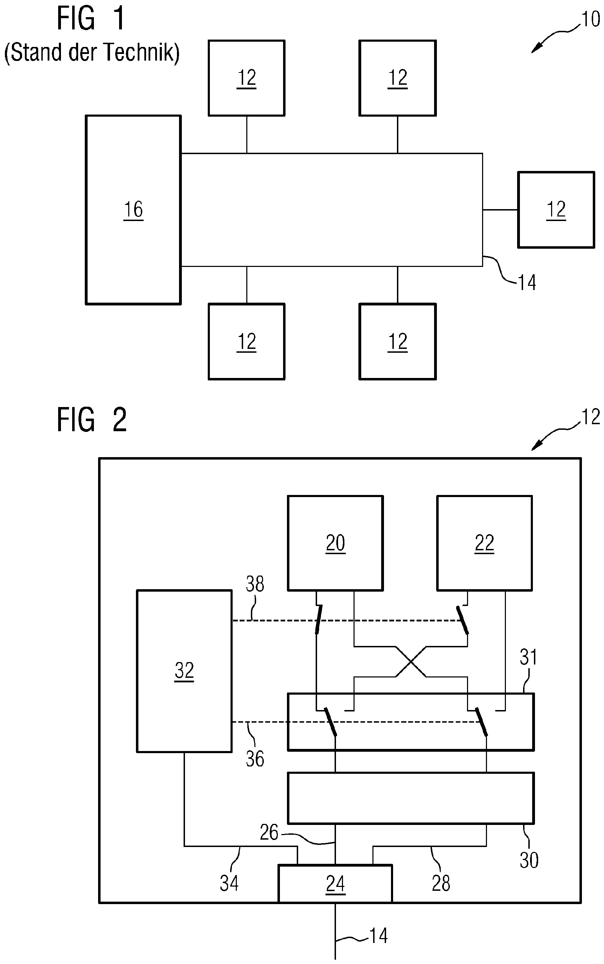

Die Darstellung in FIG 1 zeigt ein Gefahrenmeldesystem 10 mit einer Mehrzahl von im Folgenden zusammenfassend kurz als Melder 12 bezeichneten Geräten. Die Melder 12 sind in grundsätzlich an sich bekannter Art und Weise an ein Bussystem 14 angeschlossen (Busteilnehmer). Das Bussystem 14 geht von einer am Bussystem 14 als Busmaster fungierenden Zentraleinheit 16 aus. Mittels des Bussystems 14 sind die Melder 12 in grundsätzlich an sich bekannter Art und Weise kommunikativ zumindest mit der Zentraleinheit 16 und/oder anderen an das Bussystem 14 angeschlossenen Meldern 12 verbunden.

Das Bussystem 14 ist zum Beispiel ein unter der Bezeichnung FDnet (Field Device Network) oder Cnet bekanntes Bussystem 14 oder ein vergleichbares Bussystem 14. Ein Melder 12 ist zum Beispiel eine Blitzleuchte, ein Signalhorn, ein Sprachmelder oder dergleichen. Solche Melder 12 sind in Bezug auf ihre jeweilige Alarmierungsfunktionalität sowie in Bezug auf ihren Anschluss an ein jeweiliges Bussystem 14 an sich bekannt, so dass hier insoweit keine weitere Beschreibung erfolgt und stattdessen auf den Stand der Technik verwiesen wird.

Die Darstellung in FIG 2 zeigt einen einzelnen Melder 12 mit weiteren Details. Danach umfasst der Melder 12 nach dem hier vorgeschlagenen Ansatz eine nur schematisch vereinfacht gezeigte aktivierbare Energieverbrauchssimulationseinheit 20. Die Energieverbrauchssimulationseinheit 20 wird im Folgenden mitunter kurz als Simulationseinheit 20 bezeichnet.

Neben der Simulationseinheit 20 umfasst der Melder 12 in grundsätzlich an sich bekannter Art und Weise ein ebenfalls nur schematisch vereinfacht gezeigtes aktivierbares Signalelement 22, zum Beispiel ein optisches Signalelement, ein akustisches Signalelement oder dergleichen. Durch Ansteuerung des jeweiligen Signalelements 22 übernimmt der Melder 12 seine Melde/Signalisierungsfunktion: Durch Ansteuerung des jeweiligen Signalelements 22, also zum Beispiel durch Ansteuerung eines akustischen Signalelements, zeigt der Melder 12 eine Gefahrensituation, also zum Beispiel einen Brand oder Rauchentwicklung oder dergleichen an. Ein einzelnes Signalelement 22, also zum Beispiel ein optisches Signalelement, ein akustisches Signalelement oder dergleichen, oder mehr als ein Signalelement 22, also zum Beispiel einerseits ein optisches Signalelement und andererseits ein akustisches Signalelement oder dergleichen, werden im Folgenden einzeln und zusammen kurz als Signalelement 22 bezeichnet.

Der Melder 12 ist entsprechend der hier vorgeschlagenen Neuerung dafür bestimmt und eingerichtet, die Simulationseinheit 20 anstelle des von dem Melder 12 umfassten Signalelements 22 an das Bussystem 14 anzuschalten.

Die Simulationseinheit 20 eines Melders 12 ist an das von dem Melder 12 umfasste Signalelement 22 angepasst, derart, dass die Simulationseinheit 20 - wie eingangs beschrieben - in lektrischer Hinsicht dieselben oder zumindest im Wesentlichen dieselben Eigenschaften hat wie das zu ersetzende Signalelement 22, zum Beispiel indem eine mittlere Energieaufnahme der Simulationseinheit 20 der mittleren Energieaufnahme des jeweiligen Signalelements 22 entspricht oder zumindest im Wesentlichen entspricht. Dies bedeutet, dass in einem Melder 12 dessen Signalelement 22 und die Simulationseinheit 20 dieselbe oder zumindest im Wesentlichen dieselbe Abhängigkeit ihrer Klemmenspannung von der vom Bussystem 14 bezogenen Stromstärke haben. Insbesondere wegen der Temperaturabhängigkeit der Verluste entlang des Bussystems 14 kommt es nicht auf exakt dieselben Eigenschaften von Simulationseinheit 20 und Signalelement 22 an und vielmehr sind im Wesentlichen dieselben Eigenschaften ausreichend. In diesem Sinne gilt eine Energieaufnahme der Simulationseinheit 20 im Bereich von +/- 5% oder +/- 10% der Energieaufnahme des Signalelements 22 als im Wesentlichen dieselbe Energieaufnahme wie diejenige des Signalelements 22.

Zur Veranschaulichung der alternativen Anschaltung entweder des Signalelements 22 oder der Simulationseinheit 20 an das Bussystem 14 ist in der Darstellung in FIG 2 eine von dem Melder 12 umfasste Busanschaltung 24 gezeigt. Von dieser gehen zumindest zwei von dem Bussystem 14 umfasste und beim Bussystem 14 nicht gezeigte Busleitungen 26, 28 aus. Über diese Busleitungen 26, 28 erfolgt die Energieversorgung des Signalelements 22. Dafür umfasst der Melder 12 zum Beispiel eine Versorgungseinheit 30. Die Versorgungseinheit 30 umfasst zum Beispiel einen Kondensator, aus dem ein optisches Signalelement 22 die elektrische Energie für die Aktivierung eines jeweiligen Leuchtmittels bezieht.

Zur alternativen Anschaltung entweder des Signalelements 22 oder der Simulationseinheit 20 an das Bussystem 14 umfasst der Melder 12 eine Umschalteinheit 31. Mittels der Umschalteinheit 31 ist je nach Schaltstellung davon umfasster Schaltelemente entweder das Signalelement 22 oder die Simulationseinheit 20 an die Busleitungen 26, 28 angeschlossen und damit an die Versorgungseinheit 30 oder an das Bussystem 14 angeschaltet.

Für die weitere Beschreibung kommt es nicht wesentlich darauf an, ob ein Melder 12 eine eigenständige Versorgungseinheit 30 umfasst oder nicht oder ob die Versorgungseinheit 30 zum Beispiel einerseits Teil des jeweiligen Signalelements 22 sowie andererseits Teil der parallelen Simulationseinheit 20 ist. Eine eigene Versorgungseinheit 30 oder eine zum Beispiel mit der Umschalteinheit 31 zu einer Funktions- und Versorgungseinheit zusammengefasste Einheit hat den Vorteil eines reduzierten Bauteilaufwands, denn redundante elektrische Bauteile, die gleichermaßen für die Versorgung des Signalelements 22 wie auch für die Versorgung einer während eines Tests elektrisch an die Stelle des Signalelements 22 tretenden Simulationseinheit 20 verwendbar sind, werden nur einmal benötigt und in der Versorgungseinheit 30 zusammengefasst.

Im Falle einer Versorgungseinheit 30 ist ein aktives Signalelement 22 oder eine aktive Simulationseinheit 20 mittelbar, nämlich über die Versorgungseinheit 30, an das Bussystem 14 angeschlossen/an das Bussystem 14 angeschaltet. Wenn hier und im Folgenden von einer Anschaltung an das Bussystem 14 gesprochen wird, ist dabei jeweils eine unmittelbare Anschaltung oder eine mittelbare Anschaltung über eine von dem jeweiligen Melder 12 umfasste Versorgungseinheit 30 mitzulesen.

Die Ansteuerung der Umschalteinheit 31 erfolgt mittels einer von dem Melder 12 umfassten Steuereinheit 32. Die Steuereinheit 32 und die Umschalteinheit 31 können - wie gezeigt - unabhängige Funktionseinheiten, aber alternativ auch als Einheit ausgeführt sein, sodass im letzteren Fall die Steuereinheit 32 die Umschalteinheit 31 umfasst. Die Beschreibung wird - allerdings ausdrücklich ohne einen Verzicht auf eine weitergehende Allgemeingültigkeit - auf Basis der exemplarisch gezeigten Konfiguration fortgesetzt. Danach steuert die Steuereinheit 32 die Umschalteinheit 31 an. Dies erfolgt abhängig von einem Signal oder Telegramm, welches die Steuereinheit 32 in grundsätzlich an sich bekannter Art und Weise über eine von dem Bussystem 14 umfasste und beim Bussystem 14 nicht gezeigte weitere Busleitung 34 (oder über zumindest eine der bereits erwähnten Busleitungen 26, 28) empfängt. Auf ein solches Signal oder Telegramm erzeugt die Steuereinheit 32 ein Umschaltsignal 36, welches bei der Umschalteinheit 31 einen Wechsel von deren Schaltstellung bewirkt. Schematisch vereinfacht und lediglich zur Veranschaulichung ist dies in Form einer mittels des Umschaltsignals 36 erfolgenden Ansteuerung zweier von der Umschalteinheit 31 umfasster Schaltelemente gezeigt. Eine Umschaltung der Schaltstellung der Umschalteinheit 31 bewirkt, dass anstelle eines zuvor an das Bussystem 14 angeschalteten Signalelements 22 die Simulationseinheit 20 an das Bussystem 14 angeschaltet wird und als Ergebnis der Umschaltung an das Bussystem 14 angeschaltet ist oder umgekehrt.

Bei einer Anschaltung der Simulationseinheit 20 an das Bussystem 14 ist das von dem Melder 12 umfasste Signalelement 22 elektrisch nicht aktiv und bei einer Fehlersituation auch nicht aktivierbar. Bei einer Anschaltung der Simulationseinheit 20 an das Bussystem 14 kann also entsprechend kein akustisches oder optisches Signal ausgegeben werden, auch wenn die Steuereinheit 32 aufgrund einer Fehlersituation (Brand, Rauchentwicklung oder dergleichen) ein Aktivierungssignal 38 ausgibt.

Bei einer Schaltstellung der Umschalteinheit 31, welche - wie gezeigt - bewirkt, dass anstelle des Signalelements 22 die Simulationseinheit 20 an das Bussystem 14 angeschaltet ist, wird bei einem von der Steuereinheit 32 ausgegebenen Aktivierungssignal 38 der das Bussystem 14 umfassende Stromkreis über die Simulationseinheit 20 geschlossen. Dann fließt ein Teil des über das Bussystem 14 abgegebenen Stroms über die Simulationseinheit 20 und die vom Bussystem 14 abgegebene Spannung steht über der Simulationseinheit 20 an. Die Simulationseinheit 20 tritt also als elektrische Last am Bussystem 14 in Erscheinung. Jetzt kann in dem Gefahrenmeldesystem 10 die Energieversorgung der einzelnen Melder 12 über das Bussystem 14 überprüft werden, ohne dass dabei akustische und/oder optische Signale abgegeben werden, welche Benutzer eines Gebäudes verunsichern könnten.

Die Simulationseinheit 20 ist dabei in jedem Melder 12 in der weiter oben beschriebenen Art und Weise auf die elektrischen Eigenschaften des jeweiligen Signalelements 22 abgestimmt und optional auch auf parametrierbare elektrische Eigenschaften des jeweiligen Signalelements 22 abgestimmt.

Eine parametrierbare elektrische Eigenschaft ist zum Beispiel eine parametrierte Lautstärke eines akustischen Signalelements 22, zum Beispiel eines Signalhorns. Bei einem solchen Signalelement 22 wird die parametrierbare Lautstärke mittels eines veränderlichen Widerstands eingestellt. Eine entsprechende Parametrierung einer Simulationseinheit 20, also einer Simulationseinheit 20, welche beim Belastungstest an die Stelle des akustischen Signalelements 22 mit parametrierbarer Lautstärke tritt, erfolgt zum Beispiel durch Einstellung eines von der Simulationseinheit 20 umfassten verstellbaren Widerstands. Die jeweils wirksame Größe des Widerstands wird bei einer solchen Simulationseinheit 20 zum Beispiel durch eine pulsweitenmodulierte Anschaltung des Widerstands an das Bussystem 14 bewirkt. Aufgrund einer Parametrierung der Simulationseinheit 20 resultiert dann ein entsprechender ohmscher Widerstand der Simulationseinheit 20 und zum Beispiel ein entsprechendes pulsweitenmoduliertes Signal, welches den Widerstand jeweils nur bei aktiven Pulsen des Signals an das Bussystem 14 anschaltet.

Eine parametrierbare elektrische Eigenschaft ist zum Beispiel auch eine parametrierte Lichtintensität eines optischen Signalelements 22. Eine parametrierbare elektrische Eigenschaft ist des Weiteren zum Beispiel auch eine parametrierte Frequenz, mit der ein optisches oder ein akustisches Signal abgegeben wird. Ein entsprechendes parametrierbares Signalelement 22 ist zum Beispiel eine parametrierbare Blitzleuchte, wobei als Leuchtmittel zum Beispiel eine LED fungiert, welche die elektrische Energie für einen abzugebenden Lichtblitz aus einem zuvor geladenen und von dem Signalelement 22 umfassten Kondensator bezieht. Die Parametrierung eines solchen Signalelements 22 bezieht sich dann auf die Blitzfrequenz und/oder die Intensität des abgegebenen Lichtblitzes. Beides hängt vom Ladezustand des Kondensators ab, nämlich vom Ladezustand zu dem Zeitpunkt, an dem dessen elektrische Energie auf das Leuchtmittel geschaltet wird. Eine beim Belastungstest an die Stelle eines solchen Signalelements 22 tretende Simulationseinheit 20 umfasst ebenfalls einen Kondensator (oder verwendet den Kondensator einer gemeinsamen Versorgungseinheit 30) und anstelle einer LED eine Ersatzlast, insbesondere eine Konstantstromlast. Der Kondensator der Simulationseinheit 20 wird auf denselben oder im Wesentlichen denselben Ladezustand geladen wie der Kondensator des Signalelements 22 geladen würde, so dass der mittlere Energieverbrauch der Simulationseinheit 20 beim Laden des Kondensators dem mittleren Energieverbrauch des Signalelements 22 beim Laden des dortigen Kondensators entspricht oder zumindest im Wesentlichen entspricht. Bei einem vom Signalelement 22 und von der Simulationseinheit 20 gemeinsam benutzten Kondensator einer Versorgungseinheit 30 wird sowohl für das Signalelement 22 wie auch für die Simulationseinheit 20 derselbe Kondensator geladen und beim Laden entspricht der mittlere Energieverbrauch des Kondensators zusammen mit dem Signalelement 22 dem mittleren Energieverbrauch des Kondensators zusammen mit der Simulationseinheit 20.

Mittels einer Simulationseinheit 20 in jedem an das Bussystem 14 angeschlossenen Melder 12 kann das Bussystem 14 elektrisch geprüft werden, ohne dass für Benutzer eines Gebäudes wahrnehmbare Alarmsignale oder dergleichen ausgegeben werden.

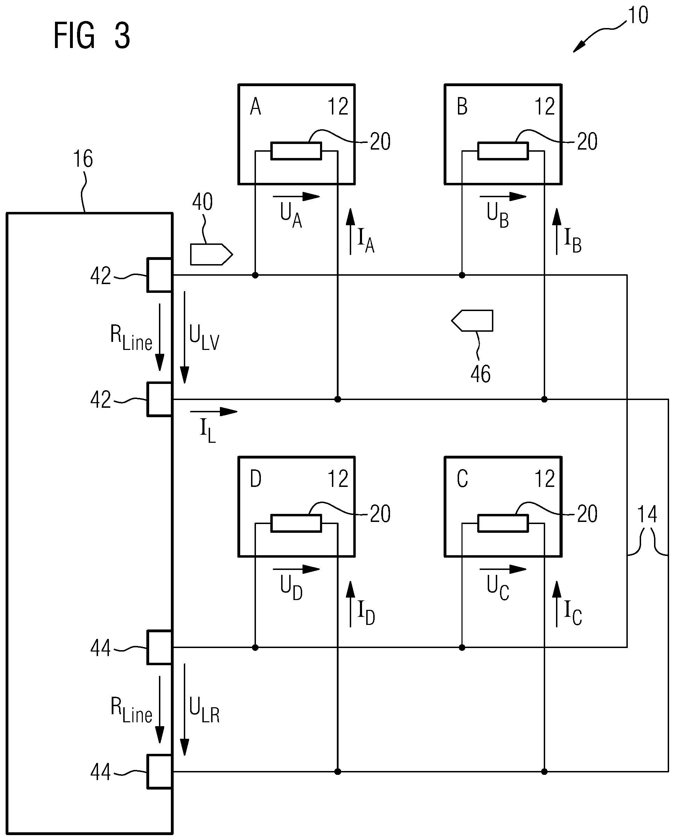

Eine solche Prüfung wird anhand der Darstellung in FIG 3 weiter erläutert. Diese zeigt - ähnlich wie die Darstellung in FIG 1 - mehrere an ein Bussystem 14 angeschlossene Melder 12 sowie eine Zentraleinheit 16, von der das Bussystem 14 ausgeht. Die an das Bussystem 14 angeschlossenen Melder 12 umfassen jeweils eine aktivierbare Simulationseinheit 20 wie in FIG 2 gezeigt und anhand von FIG 2 beschrieben. Die Darstellung zeigt die Melder 12 in schematisch stark vereinfachter Form und mit an das Bussystem 14 angeschalteten Simulationseinheiten 20.

Das Bussystem 14 ist beispielhaft als ringförmig geschlossenes Bussystem (Ring, Loop) gezeigt. Insoweit sind ein Anfang des Bussystems 14 und ein Ende des Bussystems 14 mittels erster und zweiter Anschlüsse 42, 44 an die Zentraleinheit 16 angeschlossen. Bei einer linienförmigen Bustopologie ist das Bussystem 14 nur einseitig an die Zentraleinheit 16 angeschlossen.

Für eine Prüfung (Belastungstest) der hier vorgeschlagenen Art sendet die Zentraleinheit 16 des Bussystems 14 über das Bussystem 14 an jeden Melder 12 ein den Belastungstest einleitendes Signal oder Telegramm. Dieses wird im Folgenden zusammenfassend und zur Unterscheidung von dem melderintern generierten Umschaltsignal 36 als Umschalttelegramm 40 bezeichnet. Das Umschalttelegramm 40 bewirkt bei jedem Melder 12 mit einer aktivierbaren Simulationseinheit 20, dass die Simulationseinheit 20 (anstelle des Signalelements 22) an das Bussystem 14 angeschaltet wird. Damit wird am Bussystem 14 ein Testmodus aktiviert. Der Testmodus wird zum Beispiel durch ein erneutes Senden des Umschalttelegramms 40 oder durch Senden eines speziellen Testmodusbeendigungstelegramms beendet.

Nach dem Verstreichen einer vorgegebenen oder vorgebbaren Zeitspanne nach dem Aussenden des Umschalttelegramms 40 kann davon ausgegangen werden, dass alle Melder 12 mit einer aktivierbaren Simulationseinheit 20 ihre Simulationseinheit 20 anstelle ihres Signalelements 22 an das Bussystem 14 angeschaltet haben. Dann kann der Test beginnen. Alternativ zu einem Testbeginn in Abhängigkeit vom Verstreichen einer Wartezeit nach dem Aussenden des Umschalttelegramms 40 kann auch jeder Melder 12 mit einer aktivierbaren Simulationseinheit 20 nach dem Anschalten der Simulationseinheit 20 an das Bussystem 14 ein entsprechendes Signal oder Telegramm an die Zentraleinheit 16 senden. Dann beginnt der Test nach dem Empfang eines solchen Signals oder Telegramms von allen Meldern 12 mit einer aktivierbaren Simulationseinheit 20.

Während des Tests werden alternativ oder kumulativ verschiedenste Strom- und Spannungsmessungen durchgeführt. Zum Beispiel kann jeder Melder 12 den über die Simulationseinheit 20 fließenden Strom und/oder die über der Simulationseinheit 20 anstehende Spannung erfassen und das Messergebnis oder die Messergebnisse kodierenden Werte für einen späteren Abruf durch die Zentraleinheit 16 speichern. Genauso kann die Zentraleinheit 16 die an das Bussystem 14 abgegebene Spannung und oder den in das Bussystem 14 abgegebenen Strom erfassen und das Messergebnis oder die Messergebnisse kodierenden Werte speichern. Die Zentraleinheit 16 des Bussystems 14 ist diejenige Funktionseinheit innerhalb des Gesamtsystems - des Gefahrenmeldesystems 10 -, welche den Belastungstest auslöst, automatisch steuert und überwacht und automatisch auswertet, Letzteres zum Beispiel durch Generierung eines Alarmsignals und/oder einer Fehlermeldung.

In der Darstellung in FIG 3 sind die dort exemplarisch als an das Bussystem 14 angeschlossen gezeigten Melder 12 symbolisch zusätzlich mit "A", "B", "C" und "D" bezeichnet. In einem realen Gefahrenmeldesystem 10 sind an das Bussystem 14 üblicherweise erheblich mehr als die lediglich beispielhaft gezeigten vier Melder 12 angeschlossen. Die von jedem Melder 12 über dessen Simulationseinheit 20 erfassbaren Spannungen sind mit Bezug auf diese symbolischen Bezeichnungen als U_{A}, U_{B}, U_{C} bzw. U_{D} eingezeichnet. Ebenfalls mit Bezug auf diese symbolischen Bezeichnungen sind die von jedem Melder 12 über dessen Simulationseinheit 20 erfassbaren Ströme als I_{A}, I_{B}, I_{C} bzw. I_{D} eingezeichnet.

Mittels grundsätzlich optionaler Spannungsmessungen überwacht während des Tests jeder Melder 12 mit einer aktivierbaren und an das Bussystem 14 angeschalteten Simulationseinheit 20 die über der Simulationseinheit 20 abfallende Spannung (U_{A}, U_{B}, U_{C} bzw. U_{D}) und speichert den sich während des Tests einstellenden minimalen Wert (U_{Amin}, U_{Bmin}, U_{Cmin} bzw. U_{Dmin}). Wenn dieser unter einen vorgegebenen oder vorgebbaren Vergleichswert, insbesondere einen vorgegebenen oder vorgebbaren melderspezifischen Vergleichswert, fällt, sendet der betroffene Melder 12 zum Beispiel ein die Spannungsunterschreitung anzeigendes Fehlertelegramm 46 an die Zentraleinheit 16. Auf den Erhalt eines solchen Telegramms 46 zeigt die Zentraleinheit 16 einen Fehler während des Tests an. Der Test ist damit nicht erfolgreich abgeschlossen.

Alternativ zu einem aktiven Aussenden eines solchen Fehlertelegramms 46 durch den Melder 12 fragt die Zentraleinheit 16 im Zusammenhang mit dem Abschluss des Tests bei jedem Melder 12 den dort jeweils gespeicherten Minimalwert ab und vergleicht diesen mit einem vorgegebenen oder vorgebbaren Vergleichswert, insbesondere einem melderspezifischen oder meldertypspezifischen Vergleichswert, und zeigt bei einer Unterschreitung einen Fehler während des Tests an. Auch dann ist der Test nicht erfolgreich abgeschlossen. Das in der Darstellung gezeigte Fehlertelegramm 46 kann insoweit auch als Antworttelegramm auf eine Abfrage durch die Zentraleinheit 16 aufgefasst werden. Das Fehlertelegramm 46 zeigt dann nicht unmittelbar eine Fehlersituation an, sondern umfasst den jeweils gespeicherten Minimalwert.

Mittels einer grundsätzlich optionalen Strommessung überwacht die Zentraleinheit 16 während des Tests den an das Bussystem 14 abgegebenen Strom (I_{L}) und vergleicht diesen mit bustreiberspezifischen und/oder quellenspezifischen Grenzwerten. Ein bustreiberspezifischer Grenzwert gibt zum Beispiel den maximal von einem Bustreiber 50 (FIG 5) abgebbaren Strom (I_{L}) an. Ein quellenspezifischer Grenzwert gibt zum Beispiel den maximal von einer Stromquelle, zum Beispiel einer Batterie, abgebbaren Strom an. Wenn die Zentraleinheit 16 ein Bussystem 14 mit mehreren Ringen oder mehreren Strängen unterstützt, werden die Ströme bevorzugt in jedem Ring bzw. jedem Strang aufaddiert und diese Summe wird dem Vergleich mit bustreiberspezifischen und/oder quellenspezifischen Grenzwerten zugrunde gelegt. Wenn eine Überschreitung zumindest eines Grenzwerts eintritt, zeigt die Zentraleinheit 16 einen Fehler während des Tests an. Der Test ist damit nicht erfolgreich abgeschlossen.

Mittels einer grundsätzlich optionalen Spannungsmessung überwacht die Zentraleinheit 16 während des Tests die an das Bussystem 14 abgegebene Spannung (Speisespannung), insbesondere indem eine eingangsseitige Spannung (U_{LV}) und eine ausgangsseitige Spannung (U_{LR}) getrennt erfasst werden. Der oder jeder bezüglich des Bussystems 14 von der Zentraleinheit 16 erfasste Spannungsmesswert wird mit einem vorgegebenen oder vorgebbaren Vergleichswert, zum Beispiel einem sich aus einer Spezifikation des jeweiligen Melders 12 ergebenden Vergleichswert, verglichen. Wenn während des Tests eine Unterschreitung zumindest eines Vergleichswerts erfolgt, zeigt die Zentraleinheit 16 einen Fehler während des Tests an. Der Test ist damit nicht erfolgreich abgeschlossen.

Die von der Zentraleinheit 16 durchgeführte Strommessung zusammen mit der von der Zentraleinheit 16 durchgeführten Spannungsmessung kann als Belastungsprüfung (load test) angesehen werden. Im Rahmen der Belastungsprüfung wird ein im Folgenden als Linienwiderstand bezeichneter Widerstandswert (R_{Line}) ermittelt und anhand des ermittelten Widerstandswerts kann eine Widerstandsreserve abgeschätzt werden. Die Widerstandsreserve ist ein Maß für die Möglichkeit, weitere Teilnehmer an das Bussystem 14 anschließen zu können, und/oder ein Maß für die Möglichkeit, zum Beispiel die Lautstärke oder die Lichtintensität einzelner Teilnehmer erhöhen zu können.

Die Zentraleinheit 16 führt den oder jeden Test aus, damit als Ergebnis des Tests eine Aussage darüber möglich ist, ob das Bussystem 14 innerhalb der vorgegebenen Grenzen betrieben wird. Testergebnisse werden bevorzugt protokolliert und/oder zur Ermittlung eines Trends protokolliert und/oder gespeichert.

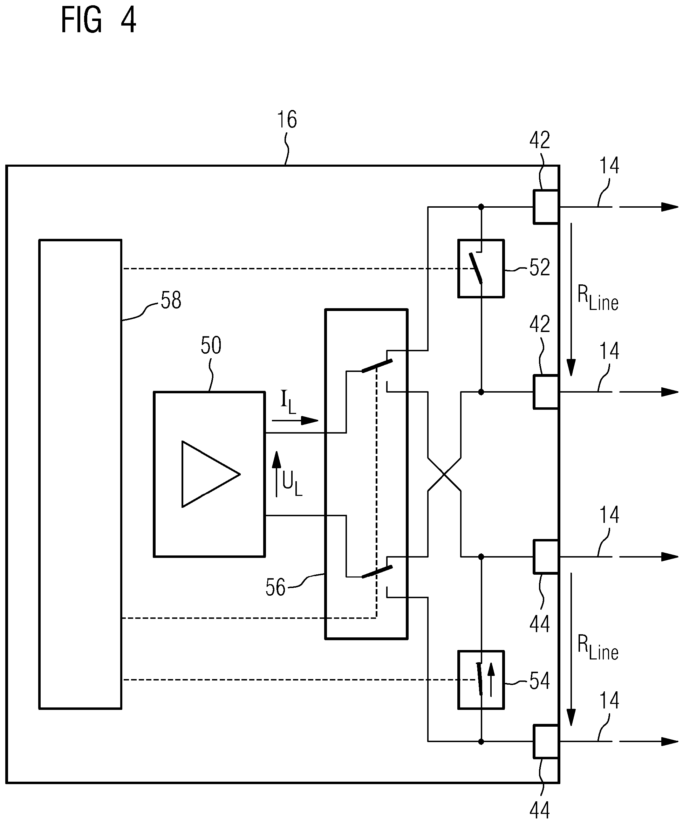

Die Darstellung in FIG 4 zeigt nur die Zentraleinheit 16 des Bussystems 14 mit weiteren Einzelheiten. Danach umfasst die Zentraleinheit 16 einen Bustreiber 50. Dieser gibt den über das Bussystem 14 übertragbaren Strom (I_{L}) und die für das Bussystem 14 zur Verfügung stehende Spannung (U_{L}) aus.

Mittels des Bustreibers 50 kann die Zentraleinheit 16 die an das Bussystem 14 abgegebene Spannung (U_{L}) - Speisespannung-sukzessive, insbesondere für eine spezielle Ausführungsform des Belastungstests (wie in der Beschreibungseinleitung erwähnt), reduziert werden.

Bei einem Bussystem 14 mit einer ringförmigen Topologie - wie gezeigt - ist das Bussystem 14 optional beidseitig terminierbar. Dafür umfasst die Zentraleinheit 16 jeweils ein den Anschlüssen 42 und den Anschlüssen 44 zugeordnetes Busabschlussschaltelement 52, 54. Je nach Schaltstellung des Busabschlussschaltelements 52, 54 sind die Anschlüsse 42 oder die Anschlüsse 44 elektrisch leitend miteinander verbunden. Mit einem aktivierten Busabschlussschaltelement 52, 54 - wie dies exemplarisch für das Busabschlussschaltelement 54 an den Anschlüssen 44 gezeigt ist - endet das Bussystem 14 am aktivierten Busabschlussschaltelement 54. Mittels einer Busrichtungsumschalteinheit 56 ist einstellbar, ob der vom Bustreiber 50 abgegebene Strom an den Anschlüssen 42 oder an den Anschlüssen 44 eingespeist wird. Die Schaltstellung der Busrichtungsumschalteinheit 56 und die Schaltstellung der Busabschlussschaltelemente 52, 54 sind miteinander koordiniert: An den Anschlüssen 42, 44, an denen nicht eingespeist wird, ist das dortige Busabschlussschaltelement 52, 54 geschlossen. Mittels der Busrichtungsumschalteinheit 56 und der Busabschlussschaltelemente 52, 54 ist die Richtung, in der das Bussystem 14 betrieben wird, umkehrbar. In einem Fall wird der vom Bustreiber 50 abgegebene Strom an den Anschlüssen 42 eingespeist. Dann werden die den Anschlüssen 42 nachfolgenden Melder 12 in der Reihenfolge ihres Anschlusses an das Bussystem 14 mit elektrischer Energie versorgt. Im anderen Fall wird der vom Bustreiber 50 abgegebene Strom an den Anschlüssen 44 eingespeist. Dann werden die den Anschlüssen 44 nachfolgenden Melder 12 in deren Anschlussreihenfolge mit elektrischer Energie versorgt. Die koordinierte Ansteuerung der Busrichtungsumschalteinheit 56 und der Busabschlussschaltelemente 52, 54 erfolgt mittels einer von der Zentraleinheit 16 umfassten Verarbeitungseinheit 58, zum Beispiel einer Verarbeitungseinheit 58 in Form eines Mikrocontrollers oder eines Mikroprozessors. Die Verarbeitungseinheit 58 kann darüber hinaus weitere Funktionen erfüllen, zum Beispiel das Senden und Empfangen von Telegrammen über das Bussystem 14 und/oder die Überwachung des Busausbaus, also die Überwachung der Anzahl angeschlossener Melder 12. Optional steuert und überwacht die Verarbeitungseinheit 58 die hier vorgeschlagenen Tests.

Mit einem in dieser Form hinsichtlich der Speiserichtung umschaltbaren Bussystem 14 kann der oben beschriebene Test in zwei Abschnitten ausgeführt werden. Dabei wird in einem zeitlich ersten Abschnitt zumindest einer der oben beschriebenen Tests bei einem Betrieb des Bussystems 14 mit einer ersten Speiserichtung (zum Beispiel einer Einspeisung des vom Bustreiber 50 abgegebenen Stroms an den Anschlüssen 42) durchgeführt. Anschließend wird in einem zeitlich zweiten Abschnitt zumindest einer der oben beschriebenen Tests bei einem Betrieb des Bussystems 14 mit einer zweiten Speiserichtung (zum Beispiel einer Einspeisung des vom Bustreiber 50 abgegebenen Stroms an den Anschlüssen 44) durchgeführt.

Obwohl die Erfindung im Detail durch das Ausführungsbeispiel näher illustriert und beschrieben wurde, so ist die Erfindung nicht durch das oder die offenbarten Beispiele eingeschränkt und andere Variationen können vom Fachmann hieraus abgeleitet werden, ohne den Schutzumfang der Erfindung zu verlassen.

Einzelne im Vordergrund stehende Aspekte der hier eingereichten Beschreibung lassen sich damit kurz wie folgt zusammenfassen:
Angegeben werden ein Verfahren zum Test eines Gefahrenmeldesystems 10 und ein in einem Gefahrenmeldesystem 10 verwendbarer Melder 12, der zur Durchführung des Verfahrens und zur Verwendung im Rahmen des Verfahrens bestimmt und eingereicht ist. Das Verfahren zum Test eines Gefahrenmeldesystems 10 ist ein Verfahren zum Test des Gefahrenmeldesystems 10 im Betrieb und unter Betriebsbedingungen. Das Verfahren zum Test eines Gefahrenmeldesystems 10 ist ein Belastungstest des Gefahrenmeldesystems 10, des Bussystems 14 des Gefahrenmeldesystems 10 und der an das Bussystem 14 angeschlossenen Melder 12. Das Gefahrenmeldesystem 10 umfasst in grundsätzlich an sich bekannter Art und Weise eine Mehrzahl von an ein Bussystem 14 angeschlossenen Meldern 12. Jeder Melder 12 umfasst zumindest ein Signalelement 22, also zum Beispiel ein Signalelement 22 zur Abgabe akustischer oder optischer Alarmsignale. Jeder Melder 12 umfasst zusätzlich zu dem zumindest einen Signalelement 22 eine aktivierbare Energieverbrauchssimulationseinheit 20. Die Energieverbrauchssimulationseinheit 20 eines Melders 12 hat dieselben oder zumindest im Wesentlichen dieselben elektrischen Eigenschaften wie das oder jedes Signalelement 22 des jeweiligen Melders 12. Jeder Melder 12 schaltet seine Energieverbrauchssimulationseinheit 20 auf einen Erhalt eines Umschalttelegramms 40 anstelle des oder jedes von dem jeweiligen Melder 12 umfassten Signalelements 22 an das Bussystem 14 an. Aufgrund derselben oder zumindest im Wesentlichen derselben elektrischen Eigenschaften der Energieverbrauchssimulationseinheit 20 und dem oder jedem Signalelement 22 ändern sich durch die Anschaltung der Energieverbrauchssimulationseinheit 20 die Verhältnisse am Bussystem 14 nicht. Im Rahmen des Belastungstests wird ein aufgrund der Aktivierung jeder Energieverbrauchssimulationseinheit 20 resultierender Energieverbrauch im Bussystem 14 und/oder spezifisch in jedem Melder 12 erfasst und mit vorgegebenen oder vorgebbaren Vergleichswerten verglichen. In Abhängigkeit vom Ergebnis des Vergleichs wird ggf. ein Alarmsignal und/oder eine Fehlermeldung generiert.

### Bezugszeichenliste

- 10: Gefahrenmeldesystem
- 12: Melder
- 14: Bussystem
- 16: Zentraleinheit
- 18: (frei)
- 20: Energieverbrauchssimulationseinheit, Simulationseinheit
- 22: Signalelement
- 24: Busanschaltung
- 26: Busleitung
- 28: Busleitung
- 30: Versorgungseinheit
- 31: Umschalteinheit
- 32: Steuereinheit
- 34: (weitere) Busleitung
- 36: Umschaltsignal
- 38: Aktivierungssignal
- 40: Umschalttelegramm
- 42: (erster) Anschluss
- 44: (zweiter) Anschluss
- 46: Fehlertelegramm
- 48: (frei)
- 50: Bustreiber
- 52: Busabschlussschaltelement
- 54: Busabschlussschaltelement
- 56: Busrichtungsumschalteinheit
- 58: Verarbeitungseinheit

## Patentansprüche

1. Verfahren zum Betrieb eines Gefahrenmeldesystems (10) mit einer Mehrzahl von an ein Bussystem (14) angeschlossenen Meldern (12) mit jeweils zumindest einem Signalelement (22),
- wobei jeder Melder (12) eine aktivierbare Energieverbrauchssimulationseinheit (20) umfasst,
- wobei jeder Melder (12) seine Energieverbrauchssimulationseinheit (20) auf einen Erhalt eines Umschalttelegramms (40) anstelle des oder jedes von dem jeweiligen Melder (12) umfassten Signalelements (22) an das Bussystem (14) anschaltet,
- wobei im Rahmen eines Belastungstests ein aufgrund der Aktivierung jeder Energieverbrauchssimulationseinheit (20) resultierender Energieverbrauch im Bussystem (14) und/oder spezifisch in jedem Melder (12) erfasst und mit vorgegebenen oder vorgebbaren Vergleichswerten verglichen wird und
- wobei in Abhängigkeit vom Ergebnis des Vergleichs ein Alarmsignal und/oder eine Fehlermeldung generiert wird.

2. Verfahren nach Anspruch 1,
- wobei eine am Bussystem (14) als übergeordnete Einheit fungierende Zentraleinheit (16) während des Belastungstests einen aufgrund der Aktivierung der oder jeder Energieverbrauchssimulationseinheit (20) resultierenden Energieverbrauch im Bussystem (14) erfasst sowie mit einem vorgegebenen oder vorgebbaren Schwellwert vergleicht und
- wobei die Zentraleinheit (16) in Abhängigkeit vom Ergebnis des Vergleichs das Alarmsignal und/oder die Fehlermeldung generiert.

3. Verfahren nach Anspruch 1 oder 2,
- wobei jeder Melder (12) während des Belastungstests im Anschluss an die Aktivierung von dessen Energieverbrauchssimulationseinheit (20) Messwerte bezüglich einer über der Energieverbrauchssimulationseinheit (20) abfallenden Spannung erfasst und einen Minimalwert speichert und
- wobei eine am Bussystem (14) als übergeordnete Einheit fungierende Zentraleinheit (16) im Anschluss an den Belastungstest bei jedem Melder (12) den dort gespeicherten Minimalwert abfragt sowie mit einem vorgegebenen oder vorgebbaren Schwellwert vergleicht und
- wobei die Zentraleinheit (16) in Abhängigkeit vom Ergebnis des Vergleichs das Alarmsignal und/oder die Fehlermeldung generiert.

4. Verfahren nach Anspruch 3, wobei die Zentraleinheit (16) den Belastungstest mehrstufig durchführt und bei jeder neuen Stufe eine an das Bussystem (14) abgegebene Speisespannung reduziert.

5. Verfahren nach einem der Ansprüche 2, 3 oder 4, wobei die Zentraleinheit (16) während des Belastungstests eine Speiserichtung des Bussystems (14) umschaltet und wobei der Belastungstest vor der Umschaltung mit einer ersten Speiserichtung und nach der Umschaltung mit einer der ersten Speiserichtung entgegengesetzten zweiten Speiserichtung erfolgt.

6. Verfahren nach einem der Ansprüche 2 bis 5, wobei die Zentraleinheit (16) den Belastungstest zu vorgegebenen oder vorgebbaren Zeitpunkten automatisch durchführt.

7. Verfahren nach einem der Ansprüche 2 bis 6, wobei die Zentraleinheit (16) den Belastungstest automatisch durchführt, wenn sich die Anzahl der Melder (12) am Bussystem (14) ändert.

8. Melder (12) zum Anschluss an ein Bussystem (14) und zur Verwendung in einem Gefahrenmeldesystem (10) mit einer Mehrzahl von an ein Bussystem (14) angeschlossenen Meldern (12),
- wobei der Melder (12) zumindest ein Signalelement (22) sowie eine aktivierbare Energieverbrauchssimulationseinheit (20) umfasst,
- wobei die Energieverbrauchssimulationseinheit (20) automatisch auf einen Erhalt eines Umschalttelegramms (40) anstelle des oder jedes Signalelements (22) an das Bussystem (14) anschaltbar ist.

9. Gefahrenmeldesystem (10) mit einem Bussystem (14) und einer Mehrzahl von an das Bussystem (14) angeschlossenen Meldern (12) nach Anspruch 8 und einer als übergeordnete Einheit am Bussystem (14) fungierenden Zentraleinheit (16),
- wobei mittels der Zentraleinheit (16) ein Umschalttelegramm (40) auf das Bussystem (14) ausgebbar ist,
- wobei jeder an das Bussystem (14) angeschlossene Melder (12) auf den Erhalt des Umschalttelegramms (40) seine Energieverbrauchssimulationseinheit (20) anstelle des oder jedes von dem jeweiligen Melder (12) umfassten Signalelements (22) an das Bussystem (14) anschaltet und
- wobei die Zentraleinheit (16) die Ausführung eines Verfahrens nach einem der vorangehenden Ansprüche auslöst und überwacht.

10. Gefahrenmeldesystem (10) nach Anspruch 9, wobei mittels der Zentraleinheit (16) eine Richtung, in welcher ein Strom in das Bussystem (14) eingespeist wird, umschaltbar ist und beim Belastungstest umgeschaltet wird.

11. Gefahrenmeldesystem (10) nach Anspruch 9 oder Anspruch 10, wobei bei einem mehrstufigen Belastungstest mittels der Zentraleinheit (16) bei jeder neuen Stufe des Belastungstests eine an das Bussystem (14) abgegebene Speisespannung verringerbar ist und beim Belastungstest verringert wird.

## Claims

1. A method for operating a hazard notification system (10) comprising a plurality of notification appliances (12) connected to a bus system (14), each having at least one signal element (22),
- wherein each notification appliance (12) comprises an activatable energy consumption simulation unit (20),
- wherein, in response to receiving a switchover telegram (40), each notification appliance (12) attaches its energy consumption simulation unit (20) to the bus system (14) in place of the or each signal element (22) incorporated in the respective notification appliance (12),
- wherein an energy consumption resulting in the bus system (14) and/or specifically in each notification appliance (12) due to the activation of each energy consumption simulation unit (20) is measured in the course of a load test and compared with predefined or predefinable comparison values, and
- wherein an alarm signal and/or a fault message are/is generated as a function of the result of the comparison.

2. The method as claimed in claim 1,
- wherein a central unit (16) acting as a master unit on the bus system (14) measures an energy consumption resulting in the bus system due to the activation of the or each energy consumption simulation unit (20) during the load test and compares said measured energy consumption with a predefined or predefinable threshold value, and
- wherein the central unit (16) generates the alarm signal and/or the fault message as a function of the result of the comparison.

3. The method as claimed in claim 1 or 2,
- wherein, during the load test and following the activation of its energy consumption simulation unit (20), each notification appliance (12) captures measurement values relating to a voltage dropping across the energy consumption simulation unit (20) and stores a minimum value, and
- wherein following the load test, a central unit (16) acting as a master unit on the bus system (14) polls each notification appliance (12) for the minimum value stored therein and compares said value with a predefined or predefinable threshold value, and
- wherein the central unit (16) generates the alarm signal and/or the fault message as a function of the result of the comparison.

4. The method as claimed in claim 3, wherein the central unit (16) conducts the load test in multiple stages and at each new stage reduces a feed voltage delivered to the bus system (14).

5. The method as claimed in one of claims 2, 3 or 4, wherein the central unit (16) switches over a feed direction of the bus system (14) during the load test and wherein the load test is performed with a first feed direction prior to the switchover and with a second feed direction opposite to the first feed direction after the switchover.

6. The method as claimed in one of claims 2 to 5, wherein the central unit (16) performs the load test automatically at predefined or predefinable times.

7. The method as claimed in one of claims 2 to 6, wherein the central unit (16) automatically performs the load test when the number of notification appliances (12) connected to the bus system (14) changes.

8. A notification appliance (12) for connecting to a bus system (14) and for use in a hazard notification system (10) comprising a plurality of notification appliances (12) connected to a bus system (14),
- wherein the notification appliance (12) comprises at least one signal element (22) as well as an activatable energy consumption simulation unit (20),
- wherein, in response to receiving a switchover telegram (40), the energy consumption simulation unit (20) can be automatically attached to the bus system (14) in place of the or each signal element (22).

9. A hazard notification system (10) comprising a bus system (14) and a plurality of notification appliances (12) connected to the bus system (14) as claimed in claim 8 and a central unit (16) acting as a master unit on the bus system (14),
- wherein a switchover telegram (40) can be output onto the bus system (14) by means of the central unit (16),
- wherein, in response to receiving the switchover telegram (40), each notification appliance (12) connected to the bus system (14) attaches its energy consumption simulation unit (20) to the bus system (14) in place of the or each signal element (22) incorporated in the respective notification appliance (12), and
- wherein the central unit (16) initiates and monitors the performance of a method as claimed in one of the preceding claims.

10. The hazard notification system (10) as claimed in claim 9, wherein a direction in which a current is fed into the bus system (14) can be switched over by means of the central unit (16) and is switched over during the load test.

11. The hazard notification system (10) as claimed in claim 9 or claim 10, wherein, during a multistage load test performed by means of the central unit (16), a feed voltage delivered to the bus system (14) can be reduced at each new stage of the load test and is reduced during the load test.

## Revendications

1. Procédé pour faire fonctionner un système de signalisation de danger (10) avec une pluralité de détecteurs (12) raccordés à un système de bus (14) avec respectivement au moins un élément de signalisation (22),
- chaque détecteur (12) comprenant une unité de simulation de consommation d'énergie activable (20),
- chaque détecteur (12) connectant au système de bus (14) son unité de simulation de consommation d'énergie (20) suite à une réception d'un télégramme d'inversion (40) au lieu du ou de chaque élément de signalisation (22) compris dans le détecteur respectif (12),
- dans le cadre d'un test de charge, une consommation d'énergie résultant de l'activation de chaque unité de simulation de consommation d'énergie (20) étant détectée dans le système de bus (14) et/ou spécifiquement dans chaque détecteur (12) et étant comparée avec des valeurs de comparaison données ou spécifiables et
- un signal d'alarme et/ou un message d'erreur étant générés en fonction du résultat de la comparaison.

2. Procédé selon la revendication 1,
- une unité centrale (16) fonctionnant sur le système de bus (14) en tant qu'unité principale détectant dans le système de bus (14), pendant le test de charge, une consommation d'énergie résultant de l'activation de la ou de chaque unité de simulation de consommation d'énergie (20) et la comparant avec une valeur seuil donnée ou spécifiable et
- l'unité centrale (16) générant le signal d'alarme et/ou le message d'erreur en fonction du résultat de la comparaison.

3. Procédé selon la revendication 1 ou 2,
- chaque détecteur (12) détectant, pendant le test de charge, à la suite de l'activation de son unité de simulation de consommation d'énergie (20), des valeurs de mesure relatives à une tension en chute au-dessus de l'unité de simulation de consommation d'énergie (20) et sauvegardant une valeur minimum et
- une unité centrale (16) fonctionnant sur le système de bus (14) en tant qu'unité principale interrogeant, à la suite du test de charge, au niveau de chaque détecteur (12), la valeur minimum qui y est stockée et la comparant avec une valeur seuil donnée ou spécifiable, et
- l'unité centrale (16) générant le signal d'alarme et/ou le message d'erreur en fonction du résultat de la comparaison.

4. Procédé selon la revendication 3, l'unité centrale (16) effectuant le test de charge en plusieurs étapes et réduisant à chaque nouvelle étape une tension d'alimentation délivrée au système de bus (14).

5. Procédé selon l'une des revendications 2, 3 ou 4, l'unité centrale (16) inversant un sens d'alimentation du système de bus (14) pendant le test de charge et le test de charge ayant lieu, avant l'inversion, avec un premier sens d'alimentation et, après l'inversion, avec un deuxième sens d'alimentation opposé au premier sens d'alimentation.

6. Procédé selon l'une des revendications 2 à 5, l'unité centrale (16) effectuant le test de charge automatiquement à des instants donnés ou spécifiables.

7. Procédé selon l'une des revendications 2 à 6, l'unité centrale (16) effectuant le test de charge automatiquement lorsque le nombre de détecteurs (12) sur le système de bus (14) se modifie.

8. Détecteur (12) pour raccordement à un système de bus (14) et pour utilisation dans un système de signalisation de danger (10) avec une pluralité de détecteurs (12) raccordés à un système de bus (14),
- le détecteur (12) comprenant au moins un élément de signalisation (22) et une unité de simulation de consommation d'énergie activable (20),
- l'unité de simulation de consommation d'énergie (20) pouvant être connectée automatiquement au système de bus (14) suite à une réception d'un télégramme d'inversion (40) au lieu du ou de chaque élément de signalisation (22).

9. Système de signalisation de danger (10) avec un système de bus (14) et une pluralité de détecteurs (12) selon la revendication 8 raccordés au système de bus (14) et une unité centrale (16) fonctionnant en tant qu'unité principale sur le système de bus (14),
- un télégramme d'inversion (40) pouvant être émis sur le système de bus (14) au moyen de l'unité centrale (16),
- chaque détecteur (12) raccordé au système de bus (14) connectant, suite à la réception du télégramme d'inversion (40), son unité de simulation de consommation d'énergie (20) au lieu du ou de chaque élément de signalisation (22) compris dans le détecteur respectif (12) au système de bus (14) et
- l'unité centrale (16) déclenchant et surveillant l'exécution d'un procédé selon l'une des revendications précédentes.

10. Système de signalisation de danger (10) selon la revendication 9, au moyen de l'unité centrale (16), un sens dans lequel un courant est injecté dans le système de bus (14) pouvant être inversé et étant inversé lors du test de charge.

11. Système de signalisation de danger (10) selon la revendication 9 ou la revendication 10, lors d'un test de charge en plusieurs étapes, au moyen de l'unité centrale (16), à chaque nouvelle étape du test de charge, une tension d'alimentation délivrée au système de bus (14) pouvant être réduite et étant réduite lors du test de charge.
